# FASCICULE DE BREVET EUROPEEN

(11) **EP 3 714 204 B1**
(45) Date de publication et mention de la délivrance du brevet: **07.10.2026**
(21) Numéro de dépôt: 18808287.9
(22) Date de dépôt: 21.11.2018
(51) Int. Cl.: F21S 10/04, H05K 1/00, F21Y 115/10, F21W 121/00

(54) **LUMINAIRE À BASE DE DIODES ÉLECTROLUMINESCENTES**
LEUCHTE AUF DER BASIS VON LEUCHTDIODEN
LUMINAIRE BASED ON LIGHT-EMITTING DIODES

(30) Priorité: 21.11.2017 FR 1761002; 24.11.2017 FR 1761143
(43) Date de publication de la demande: 30.09.2020
(73) Titulaire: Chrysalis, 54670 Custines (FR)
(72) Inventeur: MARCHAL, Adrien, 54000 Nancy (FR)
(74) Mandataire: Mundel, Lysiane
(86) Numéro de dépôt international: PCT/EP2018/082137
(87) Numéro de publication internationale: WO 2019/101824

(56) Documents cités:
- EP-A1- 2 827 056
- WO-A1-2016/155521
- WO-A1-2016/177021
- CN-A- 101 603 661
- CN-U- 203 585 849
- CN-U- 204 901 648
- CN-U- 206 001 393
- CN-U- 206 617 892
- CN-Y- 201 209 807
- GB-A- 2 548 751
- US-A1- 2009 313 866
- US-A1- 2012 268 936
- US-A1- 2016 057 829
- US-A1- 2016 327 227

## Description

La présente invention a trait d'une part à un luminaire à base de diodes électroluminescentes simulant l'apparence d'une flamme, et d'autre part à un procédé de simulation de l'apparence d'une flamme à partir de diodes électroluminescentes dans un tel luminaire.

La réalisation de fausses flammes est connue par exemple sur des bougies, imitant dans ce cas les vacillements du feu sur une mèche notamment dus, dans la réalité, aux perturbations très locales d'aérologie résultant de la configuration de la zone de combustion et des gradients de température qui s'y produisent. L'illusion est créée par une mini-ampoule transparente recréant la forme d'une flamme, dont le volume intérieur est muni d'une diode électroluminescente commandée électroniquement pour faire varier sa luminance selon un schéma temporel qui peut donner l'impression d'une flamme qui vacille.

Le problème qui est posé dans le cadre de la présente invention est tout autre. Il s'agit de concevoir un luminaire capable de réaliser un éclairage public, dont le potentiel d'éclairage est donc sans commune mesure avec celui d'une bougie à simple diode, mais qui organise au contraire le fonctionnement simultané d'une pluralité de diodes d'une part en vue d'atteindre un niveau de luminance adapté à son objet, et d'autre part de le faire en conférant à l'ensemble un aspect se rapprochant le plus possible du fonctionnement apparent d'une flamme. La flamme reproduite est donc dimensionnée pour être visible de loin, et elle implique par conséquent un certain nombre de diodes électroluminescentes qu'il faut faire fonctionner simultanément.

En d'autres termes, outre l'objectif purement fonctionnel lié au niveau d'éclairagisme, le luminaire de l'invention est supposé mettre la lumière en mouvement selon un effet luminotechnique rappelant la combustion d'une flamme, à l'image des systèmes d'éclairage qui équipaient les cités d'antan, aux premiers temps de l'éclairage public. En ces temps-là, la lumière artificielle était en mouvement grâce à la combustion d'un solide ou d'un liquide. Depuis l'arrivée de l'électricité, cette lumière artificielle est devenue statique, offrant seulement 3 fonctions : allumage, extinction et puissance. L'idée à la base de l'invention est de reproduire le plus fidèlement possible l'image d'une flamme vacillante en tirant profit de l'efficacité de la technologie des diodes électroluminescentes, souvent désignées avec leur acronyme anglo-saxon LED (pour Light Emitting Diode), dans le domaine de l'éclairage des villes, tout en conférant aux quartiers équipés de ces luminaires le charme discret et chaleureux des ambiances désuètes qui en résultent.

Dans la présente invention et conformément à ce qui est détaillé dans la norme EN 60598-1.2.1 « un luminaire est un appareil qui répartit, filtre ou transforme la lumière émise par une ou plusieurs lampes et qui comporte non les lampes elles-mêmes, mais toutes les pièces nécessaires pour le support, la fixation et la protection des lampes et, si nécessaire, les circuits auxiliaires et les moyens de branchement de ceux-ci au réseau d'alimentation » ; ainsi un luminaire implique l'utilisation de lampes mais n'est pas une lampe. Les contraintes des luminaires destinés à l'éclairage public, souvent urbain, sont spécifiques : éclairage assez puissant et judicieusement placé pour assurer la sûreté et la commodité du passage sur la voie publique (Art. L.2212-2 du Code général des collectivités territoriales) tout en réduisant et limitant les nuisances lumineuses et les consommations d'énergie (Art. R.583-2 du Code de l'environnement). Dans cet objectif l'utilisation de diodes électroluminescentes paraît donc parfaitement adaptée à une utilisation comme source lumineuse dans un luminaire destiné à l'éclairage public. En effet les diodes électroluminescentes ont une durée de vie supérieure et des consommations électriques très inférieures aux autres sources lumineuses communément utilisées dans les luminaires destinés à l'éclairage public.

Techniquement, le défi est multiple dans la mesure où assurer un éclairage public efficace nécessite l'utilisation d'un grand nombre de diodes par luminaire, lesquelles occupent par conséquent des surfaces ou volumes non négligeables dans celui-ci, diodes qu'il faut en plus organiser et commander en vue de la reproduction la plus réaliste possible de l'apparence d'une flamme. Par ailleurs, l'éclairage doit être multidirectionnel, et d'efficacité sensiblement équivalente dans toutes les directions couvertes, au moins horizontalement. Enfin, l'illusion de l'existence d'une flamme vacillante doit aussi être obtenue avec le même effet visuel global quel que soit l'emplacement de vision. Il s'agit là de reproduire l'éclairage réalisé par une flamme grâce à un effet luminotechnique (lumière vacillante et d'intensité variable) et non pas de reproduire une flamme observable à l'œil nu. Cet effet luminotechnique est réalisé comme décrit ci-après afin de répondre aux contraintes liées à une utilisation dans un luminaire destiné à l'éclairage public, c'est-à-dire avec une certaine puissance lumineuse. Le résultat est un éclairage de la voie publique à la manière d'une flamme et non pas la reproduction d'une flamme observable par un passant.

Le document CN101603661A divulgue un luminaire selon le préambule de la revendication 1.

En vue de la satisfaction de ces objectifs, ainsi que d'autres qui apparaîtront dans la suite, le luminaire de l'invention est notamment tel qu'il comporte :
- une pluralité de modules électroniques comportant chacun une plaque à circuit imprimé équipée d'un réseau de diodes électroluminescentes et d'un circuit répartiteur pilotant l'allumage des diodes selon une commande d'intensité individualisée, lesdits modules étant reliés par des moyens de connexion électrique ;
- un support pour fixer les plaques à circuit imprimé des modules électroniques selon une orientation propre à chaque plaque, l'ensemble des plaques étant fixé de sorte que la lumière soit distribuée dans tout l'espace ;
- un microcontrôleur de gestion des modules électroniques relié à chaque répartiteur et comprenant des moyens mémoire de stockage d'au moins un programme d'allumage des diodes électroluminescentes.

Ledit luminaire est particulièrement adapté à l'éclairage public.

Les diodes sont de fait réparties sur des modules d'allure plutôt bidimensionnelle, puisque basés sur les plaques à circuit imprimé, qui sont ensuite assemblés pour conférer à l'ensemble un caractère tridimensionnel et permettre ainsi un éclairage périphérique. Lesdits modules comprennent de plus des moyens électroniques de gestion de l'illumination contrôlée des diodes, à la fois pour chaque module et le cas échéant sur plusieurs modules. Les diodes électroluminescentes sont donc pilotées, dans chaque module, par un circuit électronique conçu pour reproduire différents scénarios d'illumination provenant du microcontrôleur. Les transferts de données sont séquencés via une horloge interne qui reproduit indéfiniment un programme sélectionné qui tourne en boucle. Il a pour fonction essentielle d'allumer les diodes électroluminescentes non pas au hasard mais avec une intensité variable afin de reproduire une flamme « vivante » dans chaque module électronique, c'est-à-dire sur chaque plaque à circuit imprimé recevant les diodes.

Selon l'invention, le microcontrôleur est placé sur la plaque à circuit imprimé d'un des modules électroniques, bien qu'il participe en réalité à la gestion de tous les modules. Les données et instructions qui en émanent sont alors véhiculées notamment par les moyens de connexion électrique qui relient les différents modules.

En fait d'assemblage tridimensionnel, les plaques à circuit imprimé des modules électroniques peuvent être installées pour former avec le support un volume polyédrique dont une base est constituée dudit support, les diodes électroluminescentes étant alors placées sur les faces extérieures du polyèdre. Plus précisément encore, les plaques à circuit imprimé sont de préférence rectangulaires, et le support est constitué d'un polygone à n côtés, n étant égal au nombre de modules électroniques à y monter. Selon une configuration préférentielle, n peut d'ailleurs être égal à 8, ce chiffre aboutissant à une bonne répartition dans l'espace des images des flammes telles qu'elles sont « scénarisées » par les diodes en fonctionnement. En pratique, selon le montage de l'invention, la source lumineuse est verticale et diffuse dans ce cas de la lumière sur 360° au moyen de 8 images qui donnent l'impression de se confondre et donnent une perception fluide et unitaire de la flamme virtuelle, notamment lorsqu'on se déplace par rapport au luminaire.

Avantageusement, pour obtenir la meilleure représentation possible des images de flammes en mouvement, les diodes électroluminescentes sont disposées en quinconce dans une surface d'allure rectangulaire délimitée sur la plaque à circuit imprimé, ce qui contribue à éviter une multiplication indue du nombre de diodes sur chaque module électronique. Dans les faits, chaque plaque à circuit imprimé comporte entre 20 et 30 diodes et, dans le cadre de l'invention, de préférence 24 diodes. Dans l'hypothèse précédente de 8 modules électroniques, on aboutit alors à un nombre total de 192 diodes, pour une puissance maximale d'environ 140 W.

Pour une reproduction plus fidèle de l'image d'une flamme, et bien que cela ne soit pas limitatif car sujet à appréciation subjective, les diodes électroluminescentes peuvent présenter une température de couleur comprise entre 2600° K et 2800° K. Par ailleurs, à des fins d'efficacité dans la réalisation de l'éclairage public combinée à un objectif toujours présent d'économie d'énergie, les diodes sélectionnées présentent de préférence une luminance comprise entre 100 lm et 120 lm. Pour mémoire, le flux lumineux maximal d'un tel luminaire, si toutes les diodes étaient allumées, serait de l'ordre de 20000 lm. Les programmes de pilotage de l'intensité d'illumination des diodes mis en œuvre selon l'invention ne comportent cependant jamais la mise en lumière simultanée de toutes les diodes, mais d'environ un tiers de celles-ci.

La conception des modules électroniques, comportant des circuits intégrés (circuits répartiteurs, microcontrôleur) et des diodes, conduit inévitablement à une production localement concentrée de chaleur au cours du fonctionnement et il est prévu, selon l'invention, des moyens dissipateurs de la chaleur émise par les plaques à circuit imprimé des modules électroniques. Ceux-ci consistent selon l'invention en une platine en aluminium formant radiateur et constituant au surplus le support de fixation des plaques à circuit imprimé. Le support remplit par conséquent deux fonctions distinctes, l'une mécanique et l'autre thermique. Une telle optimisation de la conception conduit en pratique à une simplification de montage et à une réduction des coûts.

Selon l'invention, la platine comporte une couronne extérieure munie de moyens de fixation des plaques à circuit imprimé des modules électroniques, à l'intérieur de laquelle se développent des ailettes d'allure radiale. L'idée est de trouver un compromis acceptable entre la maximisation d'une part des surfaces en contact avec l'air et d'autre part des surfaces de passage des flux d'air, également nécessaires.

Le dissipateur de chaleur en aluminium présente une très bonne conductivité thermique. Du fait que, lorsque le luminaire est en fonctionnement, seulement environ un tiers des LED fonctionnent en même temps, le dissipateur seul peut en principe suffire au refroidissement. L'échange d'air pour le refroidissement se fait, comme on l'a vu, par l'intérieur grâce aux ailettes, selon une version qui est thermiquement « passive ». Dans certaines conditions extrêmes, la chaleur peut cependant être très élevée, et un ventilateur peut dans ces hypothèses être prévu pour activer un flux d'air artificiel en vue d'améliorer le refroidissement, selon une version thermiquement « active ».

L'invention concerne également un procédé de simulation de l'apparence d'une flamme dans un luminaire tel que celui qui a été décrit auparavant. Le mouvement de la flamme est, comme décrit auparavant, piloté à partir d'une interface électronique dont l'objectif est de reproduire le plus fidèlement possible l'apparence d'une flamme vacillante en la redéfinissant au travers d'une pluralité de diodes dont l'intensité varie en suivant un programme précis. Cette reproduction la plus réaliste possible est en fait obtenue sur la base de vidéos de flammes.

Le procédé de l'invention permet de concrétiser plusieurs « scénarii » représentant divers mouvements de flammes, correspondant en pratique à plusieurs vidéos lesquelles doivent être modélisées de sorte que des données soient disponibles à chaque instant pour chaque diode. Lesdites données conditionnent principalement l'intensité qui parcourt la diode séquence après séquence, elle-même variable entre un état allumé à 100%, un état intermédiaire respectant une gradation entre 0 et 100%, ou encore un état d'extinction. Ces données constituent en fait les programmes qui reproduisent les mouvements réalistes de flammes.

De manière générale, le procédé de l'invention comporte les étapes suivantes :
- réalisation d'un programme de commande de l'intensité d'illumination des diodes électroluminescentes des modules électroniques par séquençage et traitement de vidéos ;
- mise en mémoire dans le microcontrôleur d'au moins un programme de commande de l'intensité d'illumination des diodes électroluminescentes ;
- choix d'une vidéo et envoi des données de pilotage des diodes électroluminescentes aux répartiteurs des modules électroniques.

Plus précisément, le séquençage et le traitement des vidéos en vue de la réalisation des programmes impliquent les étapes suivantes :
- sélection ou réalisation d'une vidéo de flamme ;
- conversion de la vidéo en noir et blanc ;
- élimination du halo brillant de la flamme ;
- augmentation du contraste afin d'effectuer un contourage de la flamme ;
- décomposition de la vidéo en 24 images par seconde ;
- découpage de la surface de la flamme contourée de chaque image en n zones, correspondant à l'emplacement et au nombre des diodes électroluminescentes sur la plaque à circuit imprimé des modules électroniques ;
- affectation d'une diode électroluminescente à chaque zone ;
- pour chaque image, attribution à chaque diode électroluminescente d'une valeur comprise entre 0 et 1.

En substance, une vidéo est convertie en une succession d'images fixes de flammes. Ces images doivent être mises en correspondance avec la partie des cartes électroniques dans laquelle sont implantées les diodes. La fraction d'image représentant la flamme est en fait « découpée » dans un cadre de la taille de ladite partie de circuit imprimé comportant les diodes électroluminescentes. Chaque diode devient alors la représentation d'une partie de la flamme. La surface d'implantation des 24 diodes délimite la zone de mouvement de l'ensemble de la flamme. Pour chaque image fixe telle que séquencée, les diodes qui sont à l'intérieur du contour de la flamme peuvent être pilotées de manière à être éteintes, allumées à 100% ou ayant une intensité comprise entre 0 et 100%, selon un codage fin (en l'occurrence sur 12 bits). Les diodes placées à l'extérieur du contour des flammes sont maintenues éteintes.

Selon l'invention, les données de pilotage des diodes peuvent être affectées d'un facteur de luminosité K variable entre deux valeurs bornes, contrôlant la luminance émise par le luminaire. À titre d'exemple, pour une valeur du facteur K=1, la puissance est d'environ 40W, ce qui représente une luminance d'environ 5700 lm. Pour une valeur K=5, la puissance est d'environ 80W, pour une luminance d'environ 11400 lm. En d'autres termes, pour chaque scénario, il est possible de régler la performance lumineuse en fonction de la qualité de l'image que l'on veut obtenir.

La source lumineuse globale de chaque luminaire de l'invention est conçue pour éclairer plus ou moins intensément une zone, en général piétonne, pour laquelle la qualité de l'ambiance lumineuse est privilégiée.

Avec un programme dans lequel on affecte le facteur K=1 au scénario d'éclairement, on obtient un éclairage d'ambiance. Les éclairements sont compris entre 5 et 15 lux pour une hauteur de feu de 4 m, avec un espacement entre 2 mâts de luminaires de 16 m (l'espacement est prévu égal à 4 fois la hauteur de feu). L'éblouissement est faible, l'ambiance est très agréable et les contours de la flamme sont précis.

Avec un programme dans lequel le facteur K=5, on obtient un éclairage plus performant d'environ 50%, en termes de puissance lumineuse. Les éclairements sont compris entre 8 et 25 lux, encore pour une hauteur de feu de 4 m, avec évidemment toujours un espacement entre 2 mâts de 16 m. L'éblouissement est plus élevé, mais l'ambiance générale reste acceptable.

Le choix entre l'affectation du facteur 1 et du facteur 5 dépend de la performance et de la qualité de l'image obtenue. Il est à noter que plus on recherche la performance, moins il y a de contraste.

L'invention va à présent être décrite plus en détail, en référence aux figures annexées qui représentent un exemple non limitatif de mise en œuvre de l'invention, et pour lesquelles :
- la figure 1 représente le circuit de pilotage des diodes électroluminescentes de l'invention, figuré schématiquement pour deux modules mais généralisable ;
- la figure 2 montre plus précisément le circuit de pilotage des diodes électroluminescentes d'un module électronique standard ;
- la figure 3 représente une configuration possible de support de modules/dissipateur de chaleur octogonal ;
- la figure 4 illustre, toujours dans un exemple réduit à deux modules, l'implantation des diodes électroluminescentes et le mode de liaison entre modules ; et
- la figure 5 montre le principe de visualisation de la flamme à l'aide des diodes de chaque module.

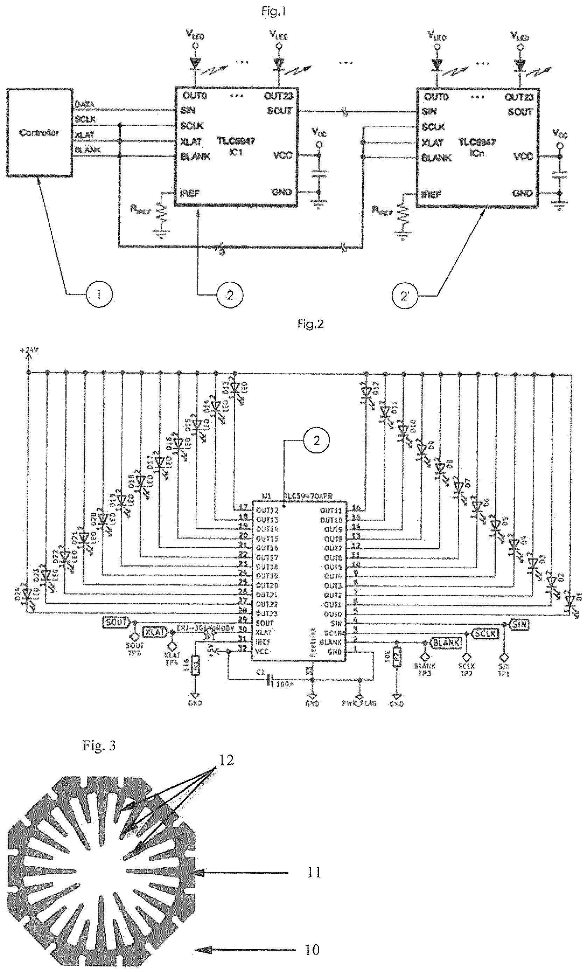

En référence à la figure 1, un microcontrôleur 1 unique, disposé sur la plaque à circuit imprimé de l'un des modules électronique, gère les circuits intégrés fonctionnant comme répartiteurs 2, 2' pilotant individuellement les diodes électroluminescentes 21 de chaque module électronique 20, 20'. Le microcontrôleur 1 gère aussi bien le circuit répartiteur 2 de la plaque à circuit imprimé sur lequel il est implanté, que ceux 2' des plaques des autres modules électroniques 20, 20'. Ces circuits répartiteurs 2, 2' sont par exemple des circuits intégrés de pilotage de diodes électroluminescentes à 24 sorties à oscillateur interne fonctionnant par exemple à 4 MHz (voir en figure 2), polarisés classiquement sous une tension de 3,0 V à 5,5 V et commercialisés sous la référence générique TLC5947 (ou sous un code produit équivalent). Les sorties de commande des diodes 21 contrôlent la luminance de manière ajustable, individuellement, selon un codage dit « grayscale » sur 12 bits fonctionnant en modulation de largeur d'impulsion. Ces sorties peuvent fournir une tension d'allumage des diodes allant jusqu'à 30 V. Les données sont envoyées de manière séquencée par un signal d'horloge géré par le microcontrôleur 1.

Différents programmes d'allumage des diodes électroluminescentes 21 sont stockés dans le microcontrôleur 1, un seul étant sélectionné à la fois, puis mis en œuvre en boucle. Les diodes 21, qui fonctionnent par exemple avec un courant de 34 mA et une tension nominale de 24 v, sont des diodes de moyenne puissance. Les programmes stockés en mémoire par le microcontrôleur permettent de les gérer individuellement avec une intensité variable, en vue de reproduire la représentation « vivante » d'une flamme vacillante. Ces programmes durent en pratique quelques dizaines de secondes, par exemple de l'ordre de 90 s.

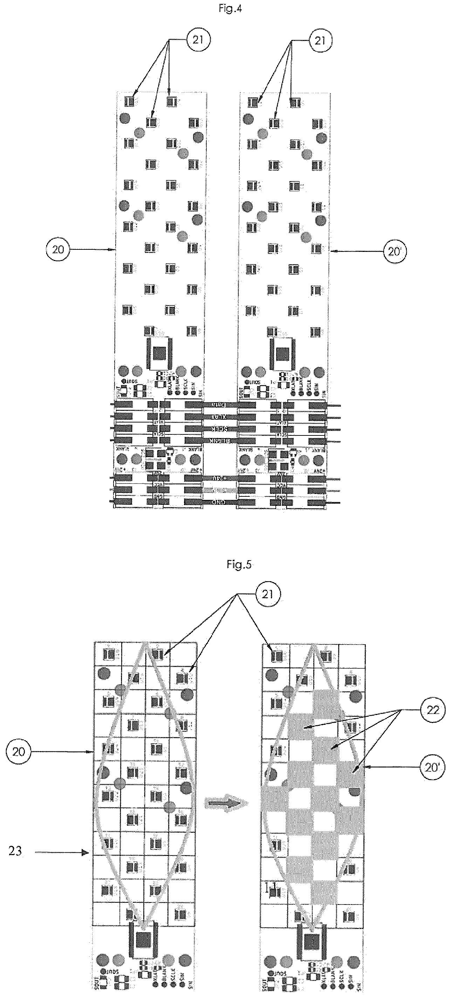

La figure 3 montre le support 10 des modules électroniques 20, 20' de la figure 4, en l'occurrence un octogone capable de recevoir 8 modules électroniques 20, 20', lesquels se présentent sous la forme de plaques à circuit imprimé rectangulaires sur lesquels sont notamment connectés les diodes 21 et les circuits intégrés 1, 2, 2'. Les modules 20, 20' sont solidarisés à la périphérie du support 10, prévu en aluminium puisqu'il sert en l'espèce également de dissipateur de chaleur. Il comporte à cet effet une couronne périphérique 11 et des ailettes intérieures 12. Lorsque le luminaire de l'invention est assemblé, le support est en principe orienté selon un axe vertical et forme avec huit plaques rectangulaires selon les modules électroniques 20, 20' un volume octaédrique dont on a souligné le caractère intéressant pour un luminaire à vocation d'éclairage public.

Les diodes électroluminescentes 21 sont alors évidemment placées sur les faces externes dudit volume, visibles de l'extérieur et assurant leur fonction d'illumination. Elles sont au nombre de 24 dans l'exemple figuré, disposées en quinconce comme cela apparaît sur la figure 4 qui montre aussi les liaisons électriques 24 entre modules 20, 20', prévues de préférence souples. Celles-ci véhiculent les signaux distribués par le microcontrôleur 1 à tous les circuits intégrés répartiteurs 2, 2', ainsi que les signaux qui relient directement lesdits circuits répartiteurs 2, 2' entre eux en vue du pilotage des diodes sur toutes les cartes des modules électroniques 20, 20'.

En référence à la figure 5, si la flamme virtualisée par le programme selon le procédé de l'invention présente à l'instant t une forme dont le contour 23 est tel que montré, seules les diodes placées à l'intérieur de ce contour 23 sont illuminées, de manière individualisée, pour que les sources de lumières 22 qu'elles constituent symbolisent ensemble une flamme. À cet égard, les intensités des signaux de commande de chacune des diodes illuminées 22 peuvent être différentes, données par le programme en fonction des degrés de luminosité relevés à leurs emplacements sur les images successives issues des vidéos à partir desquels sont construits les programmes résidents dans le microcontrôleur 1.

## Revendications

1. Luminaire à base de diodes électroluminescentes (21) simulant l'apparence d'une flamme, qui comporte :
- Une pluralité de modules électroniques (20, 20') comportant chacun une plaque à circuit imprimé équipée d'un réseau de diodes électroluminescentes (21) et d'un circuit répartiteur (2, 2') pilotant l'allumage des diodes (21) selon une commande d'intensité individualisée, lesdits modules (20, 20') étant reliés par des moyens de connexion électrique (24) ;
- un support (10) pour fixer les modules électroniques (20, 20') à plaque à circuit imprimé des modules électroniques (20, 20') selon une orientation propre à chaque plaque, l'ensemble des plaques étant fixé de sorte que la lumière soit distribuée dans tout l'espace ;
- un microcontrôleur (1) de gestion des modules électroniques (20, 20') relié à chaque circuit répartiteur (2, 2') et comprenant des moyens mémoire de stockage d'au moins un programme d'allumage des diodes électroluminescentes (21) ;
**caractérisé en ce que** :
- il comporte des moyens dissipateurs de la chaleur émise par les plaques à circuit imprimé des modules électroniques (20, 20') ; lesdits moyens constituant le support (10) de fixation des plaques à circuit imprimé des modules électroniques (20, 20') ;
- lesdits moyens dissipateurs de chaleur consistent en une platine (10) en aluminium qui comporte une couronne extérieure (11) munie de moyens de fixation des plaques à circuit imprimé des modules électroniques (20, 20'), à l'intérieur de laquelle se développent des ailettes 12 d'allure radiale;
- le microcontrôleur (1) est placé sur la plaque à circuit imprimé d'un des modules électroniques (20, 20').

2. Luminaire à base de diodes électroluminescentes (21) selon la revendication précédente, **caractérisé en ce que** les plaques à circuit imprimé des modules électroniques (20, 20') forment avec le support 10 un volume polyédrique dont une base est constituée dudit support (10), les diodes électroluminescentes (21) étant placées sur les faces extérieures du polyèdre.

3. Luminaire à base de diodes électroluminescentes (21) selon la revendication précédente, **caractérisé en ce que** les plaques à circuit imprimé sont rectangulaires, et le support (10) est constitué d'un polygone à n côtés, n'étant égal au nombre de modules électroniques (20, 20') à y monter.

4. Luminaire à base de diodes électroluminescentes (21) selon la revendication précédente, **caractérisé en ce que** n = 8.

5. Luminaire à base de diodes électroluminescentes (21) selon l'une des revendications précédentes, **caractérisé en ce que** les diodes électroluminescentes (21) sont disposées en quinconce dans une surface d'allure rectangulaire délimitée sur la plaque à circuit imprimé.

6. Luminaire à base de diodes électroluminescentes (21) selon l'une des revendications précédentes, **caractérisé en ce que** chaque plaque à circuit imprimé comporte entre 20 et 30 diodes électroluminescentes (21), de préférence 24 diodes.

7. Luminaire à base de diodes électroluminescentes (21) LED selon l'une des revendications précédentes, **caractérisé en ce que** les diodes électroluminescentes (21) présentent une température de couleur comprise entre 2600° K et 2800 ° K.

8. Luminaire à base de diodes électroluminescentes (21) selon l'une des revendications précédentes, **caractérisé en ce que** les diodes électroluminescentes (21) présentent une luminance comprise entre 100 lm et 120 lm.

9. Procédé de simulation de l'apparence d'une flamme dans un luminaire à base de diodes électroluminescentes selon l'une des revendications précédentes, comprenant les étapes suivantes :
- réalisation d'un programme de commande de l'intensité d'illumination des diodes électroluminescentes (21) des modules électroniques (20, 20') par séquençage et traitement de vidéos ;
- mise en mémoire dans le microcontrôleur (1) d'au moins un programme de commande de l'intensité d'illumination des diodes électroluminescentes (21);
- choix d'une vidéo et envoi des données de pilotage des diodes électroluminescentes (21) aux circuits répartiteurs (2, 2') des modules électroniques (20, 20');
**caractérisé en ce que** le séquençage et le traitement des vidéos pour la réalisation des programmes impliquent les étapes suivantes:
- Sélection ou réalisation d'une vidéo de flamme ;
- conversion de la vidéo en noir et blanc ;
- élimination du halo brillant de la flamme ;
- augmentation du contraste afin d'effectuer un contourage de la flamme ;
- décomposition de la vidéo en 24 images par seconde ;
- découpage de la surface de la flamme contourée de chaque image en n zones, correspondant à l'emplacement et au nombre des diodes électroluminescentes (21) sur la plaque à circuit imprimé des modules électroniques (20, 20') ;
- affectation d'une diode électroluminescente (21) à chaque zone
- pour chaque image, attribution à chaque diode électroluminescente (21) d'une valeur comprise entre 0 et 1.

10. Procédé de simulation de l'apparence d'une flamme dans un luminaire selon la revendication précédente, **caractérisé en ce que** les données de pilotage des diodes électroluminescentes (21) sont affectées d'un facteur de luminosité K variable entre deux valeurs bornes, contrôlant la luminance émise par le luminaire.

## Patentansprüche

1. Leuchte auf Basis von Elektrolumineszenz-Dioden (21), die das Aussehen einer Flamme simulieren, umfassend :
- Eine Vielzahl von Elektronikmodulen (20, 20'), die jeweils eine Leiterplatte bestückt mit einer Anordnung von Elektrolumineszenz-Dioden (21) und einer Verteilerschaltung (2, 2'), die das Einschalten der Dioden (21) gemäß einer individuellen Intensitätssteuerung steuert, aufweisen, wobei besagte Module (20, 20') über elektrische Verbindungsmittel (24) verbunden sind;
- einem Träger (10) zur Befestigung der Elektronikmodule (20, 20') mit Leiterplatte der Elektronikmodule (20, 20') in einer für jede Platte spezifischen Ausrichtung, wobei die Gesamtheit der Platten so befestigt ist, dass das Licht im gesamten Raum verteilt wird;
- einem Mikrocontroller (1) zur Verwaltung der Elektronikmodule (20, 20'), der mit jeder Verteilerschaltung (2, 2') verbunden ist und Speichermittel für mindestens ein Einschaltprogramm der Elektrolumineszenz-Dioden (21) aufweist;
**dadurch gekennzeichnet, dass** :
- es Mittel zur Ableitung der von den Leiterplatten der Elektronikmodule (20, 20') abgegebenen Wärme umfasst; genannte Mittel bilden den Träger (10) zur Befestigung der Leiterplatten der Elektronikmodule (20, 20);
- die genannten Mittel zur Ableitung der Wärme aus einer Platine (10) aus Aluminium bestehen, die einen äußeren Kranz (11) mit Befestigungsmitteln für die Leiterplatten der Elektronikmodule (20, 20') aufweist, in deren Innerem sich radial verlaufende Rippen (12) erstrecken;
- der Mikrocontroller (1) auf der Leiterplatte eines der Elektronikmodule (20, 20') angeordnet ist.

2. Leuchte auf Basis von Elektrolumineszenz-Dioden (21) nach dem vorhergehenden Anspruch, **dadurch gekennzeichnet, dass** die Leiterplatten der Elektronikmodule (20, 20') zusammen mit dem Träger (10) ein polyedrisches Volumen bilden, dessen Basis aus dem genannten Träger (10) besteht, wobei die Elektrolumineszenz-Dioden (21) auf den Außenseiten des Polyeders angeordnet sind.

3. Leuchte auf Basis von Elektrolumineszenz-Dioden (21) nach dem vorhergehenden Anspruch, **dadurch gekennzeichnet, dass** die Leiterplatten rechteckig sind und der Träger (10) aus einem n-seitigen Polygon besteht, das nicht gleich der Anzahl der daran zu montierenden Elektronikmodule (20, 20') ist.

4. Leuchte auf Basis von Elektrolumineszenz-Dioden (21) nach dem vorhergehenden Anspruch, **dadurch gekennzeichnet, dass** n = 8 ist.

5. Leuchte auf Basis von Elektrolumineszenz-Dioden (21) nach einem der vorhergehenden Ansprüche, **dadurch gekennzeichnet, dass** die Elektrolumineszenz-Dioden (21) in einem rechteckig aussehenden Bereich, der auf der Leiterplatte abgegrenzt ist, versetzt angeordnet sind.

6. Leuchte auf Basis von Elektrolumineszenz-Dioden (21) nach einem der vorhergehenden Ansprüche, **dadurch gekennzeichnet, dass** jede Leiterplatte zwischen 20 und 30 Elektrolumineszenz-Dioden (21), vorzugsweise 24 Dioden, aufweist.

7. Leuchte auf Basis von Elektrolumineszenz-Dioden (21) LED nach einem der vorhergehenden Ansprüche, **dadurch gekennzeichnet, dass** die Elektrolumineszenz-Dioden (21) eine Farbtemperatur zwischen 2600° K und 2800° K aufweisen.

8. Leuchte auf Basis von Elektrolumineszenz-Dioden (21) nach einem der vorhergehenden Ansprüche, **dadurch gekennzeichnet, dass** die Elektrolumineszenz-Dioden (21) eine Leuchtdichte zwischen 100 lm und 120 lm aufweisen.

9. Verfahren zur Simulation des Erscheinungsbildes einer Flamme in einer Leuchte aus Elektrolumineszenz-Dioden nach einem der vorhergehenden Ansprüche, das die folgenden Schritte umfasst:
- Erstellung eines Programms zur Steuerung der Beleuchtungsstärke der Elektrolumineszenz-Dioden (21) der Elektronikmodule (20, 20') durch Sequenzierung und Videoverarbeitung;
- Speicherung im Mikrocontroller (1) mindestens eines Programms zur Steuerung der Beleuchtungsstärke der Elektrolumineszenz-Dioden (21) ;
- Auswahl eines Videos und Übermittlung der Steuerdaten der Elektrolumineszenz-Dioden (21) an die Verteilerschaltungen (2, 2') der Elektronikmodule (20, 20');
**gekennzeichnet dadurch, dass** die Sequenzierung und Verarbeitung der Videos zur Erstellung der Programme folgende Schritte umfassen:
- Auswahl oder Erstellung eines Flammenvideos;
- Konvertierung des Videos in Schwarz-Weiß;
- Entfernung des Glanzhalos der Flamme;
- Erhöhung des Kontrastes, um eine Konturierung der Flamme durchzuführen;
- Zerlegung des Videos in 24 Einzelbilder pro Sekunde;
- Aufteilung der konturierten Flammenoberfläche jedes Einzelbildes in n Zonen die der Lage und der Anzahl der Elektrolumineszenz-Dioden (21) auf der Leiterplatte der Elektronikmodule (20, 20') entsprechen;
- Zuordnung einer Elektrolumineszenz-Diode (21) zu jeder Zone;
- für jedes Einzelbild Zuordnung eines Wertes zwischen 0 und 1 zu jeder Elektrolumineszenz-Diode (21).

10. Verfahren zur Simulation des Erscheinungsbildes einer Flamme in einer Leuchte nach dem vorhergehenden Anspruch, **dadurch gekennzeichnet, dass** den Steuerdaten der Elektrolumineszenz-Dioden (21) ein variabler Helligkeitsfaktor K zwischen zwei Grenzwerten zugeordnet wird, der die von der Leuchte emittierte Leuchtdichte steuert.

## Claims

1. Luminaire based on light-emitting diodes (21) simulating the appearance of a flame, that includes:
- A plurality of electronic modules (20, 20') each comprising a printed circuit board equipped with a network of light-emitting diodes (21) and a distribution circuit (2, 2') controlling the lighting of the diodes (21) according to an individualized intensity control, said modules (20, 20') being connected by electrical connection means (24);
- a support (10) for fixing the electronic modules (20, 20') printed circuit board of the electronic modules (20, 20') according to an orientation specific to each board, the set of boards being fixed so that the light is distributed throughout the space;
- a microcontroller (1) for managing the electronic modules (20, 20') connected to each distribution circuit (2, 2') and comprising memory means for storing at least one lighting program for the light-emitting diodes (21);
**characterized in that**:
- it comprises means for dissipating the heat emitted by the printed circuit boards of the electronic modules (20, 20'); said means constituting the support (10) for fixing the printed circuit boards of the electronic modules (20, 20');
- said means for dissipating the heat consist of an aluminium plate (10) comprising an outer ring (11) provided with means for fixing the printed circuit boards of the electronic modules (20, 20'), inside of which radial-shaped fins (12) develop;
- the microcontroller (1) is placed on the printed circuit board of one of the electronic modules (20, 20').

2. Luminaire based on light-emitting diodes 21 according to the preceding claim, **characterized in that** the printed circuit boards of the electronic modules (20, 20') form with the support (10) a polyhedral volume of which a base is constituted by said support (10), the light-emitting diodes (21) being placed on the outer faces of the polyhedron.

3. Luminaire based on light-emitting diodes (21) according to the preceding claim, **characterized in that** the printed circuit boards are rectangular, and the support (10) consists of a polygon with n sides, n being equal to the number of electronic modules (20, 20') to be mounted thereon.

4. Luminaire based on light-emitting diodes (21) according to the preceding claim, **characterized in that** n = 8.

5. Luminaire based on light-emitting diodes (21) according to one of the preceding claims, **characterized in that** the light-emitting diodes (21) are arranged in a staggered pattern in a rectangular-looking area delimited on the printed circuit board.

6. Luminaire based on light-emitting diodes (21) according to one of the preceding claims, **characterized in that** each printed circuit board comprises between 20 and 30 light-emitting diodes (21), preferably 24 diodes.

7. Luminaire based on light-emitting diodes (21) according to one of the preceding claims, **characterized in that** the light-emitting diodes (21) have a colour temperature of between 2600° K and 2800° K.

8. Luminaire based on light-emitting diodes (21) according to one of the preceding claims, **characterized in that** the light-emitting diodes (21) have a luminance of between 100 lm and 120 lm.

9. Method for simulating the appearance of a flame in a luminaire from light-emitting diodes according to one of the preceding claims, comprising the following steps:
- creation of a control program for the illumination intensity of the light-emitting diodes (21) of the electronic modules (20, 20') by sequencing and processing of videos;
- storing in the microcontroller (1) of at least one program for controlling the illumination intensity of light-emitting diodes (21);
- selection of a video and sending the control data of the light-emitting diodes (21) to the distribution circuits (2, 2') of the electronic modules (20, 20').
**characterized in that** the sequencing and processing of the videos for the realization of the programs involve the following steps:
- Selection or production of a flame video;
- conversion of the video to black and white;
- removal of the bright halo of the flame;
- increase in contrast in order to outline the flame;
- decomposition of the video into 24 frames per second;
- cutting the surface of the contoured flame of each image into n zones, corresponding to the location and number of light-emitting diodes (21) on the printed circuit board of the electronic modules (20, 20');
- assignment of a light-emitting diode (21) to each zone;
- for each image, assignment to each light-emitting diode (21) of a value between 0 and 1.

10. Method for simulating the appearance of a flame in a luminaire according to the preceding claim, **characterized in that** the control data of the light-emitting diodes (21) are affected by a variable brightness factor K between two terminal values, controlling the luminance emitted by the luminaire.
